# EUROPEAN PATENT APPLICATION

(11) **EP 4 763 707 A1**
(43) Date of publication of application: **24.06.2026**
(21) Application number: 25226037.7
(22) Date of filing: 19.12.2025
(51) Int. Cl.: B64D 27/357, B64D 27/33, H01M 10/48

(54) **A BATTERY AND BATTERY SUBSTRING ASSEMBLIES FOR AN AIRCRAFT PROPULSION SYSTEM**

(30) Priority: 20.12.2024 US 202418989924
(71) Applicant: Pratt & Whitney Canada Corp., (01BE5) Longueuil, QC J4G 1A1 (CA)
(72) Inventor: HANNA, Michael, Beaconsfield, J4G 1A1 (US)
(74) Representative: Dehns

(57) **Abstract**

A propulsion system (20) for an aircraft (1000) includes a battery (64) and a battery sensor assembly (92). The battery (64) includes a plurality of battery strings (74). A first battery string of the plurality of battery strings (74) includes a plurality of substring assemblies (94). Each of the substring assemblies (94) includes a battery substring (96), a first substring contactor (98), and a first substring controller (102). The battery substring (96) includes a plurality of battery cells (106) electrically connected together. The first substring contactor (98) is electrically connected with the battery substring (96). The first substring contactor (98) is positionable in a closed state or an open state. The first substring controller (102) is configured to control a position of the first substring contactor (98) in the closed state or the open state. The battery sensor assembly (92) includes a cell temperature sensor (92A) for each of the plurality of battery cells (106). The cell temperature sensor (92A) is connected in signal communication with the first substring controller (102).

## Description

### TECHNICAL FIELD

This disclosure relates generally to aircraft electrical systems including batteries and, more particularly, to battery substring assemblies and battery substring overtemperature protection.

### BACKGROUND OF THE ART

Propulsion system architectures for aircraft, such as hybrid-electric propulsion systems, may typically include one or more electrical assemblies configured to support various functions of the propulsion system and an associated aircraft. These electrical assemblies may frequently include batteries configured to provide electrical power for various electrical loads of the aircraft and its propulsion system(s). Various systems and methods for controlling and providing protective functions for these batteries are known. While these known systems and methods may be suitable for their intended purposes, there is always room in the art for improvement.

### SUMMARY

According to an aspect of the present disclosure, a propulsion system for an aircraft includes a battery and a battery sensor assembly. The battery includes a plurality of battery strings configured to be electrically connected together in parallel. A first battery string of the plurality of battery strings includes a plurality of substring assemblies. Each of the substring assemblies includes a battery substring, a first substring contactor, and a first substring controller. The battery substring includes a plurality of battery cells electrically connected together. The first substring contactor is electrically connected in series with the battery substring. The first substring contactor is positionable in a closed state or an open state. The first substring controller is connected in communication with the first substring contactor and configured to control a position of the first substring contactor in the closed state or the open state. The battery sensor assembly includes a cell temperature sensor for each of the plurality of battery cells. The cell temperature sensor for each of the plurality of battery cells is connected in signal communication with the first substring controller.

In any of the aspects or embodiments described above and herein, the first substring controller may be a simple electronic hardware (SEH) controller.

In any of the aspects or embodiments described above and herein, the first substring controller may be configured to identify a presence or an absence of an overtemperature condition in each of the plurality of battery cells using the cell temperature sensor for each of the plurality of battery cells, and the presence of the overtemperature condition may be identified for each one of the plurality of battery cells where a measured cell temperature of each respective one of the plurality of battery cells is greater than a cell temperature threshold.

In any of the aspects or embodiments described above and herein, the first substring controller may be configured to control the position of the first substring contactor in the open state in response to identifying the overtemperature condition in one of the plurality of battery cells.

In any of the aspects or embodiments described above and herein, the first substring controller may be configured to control the position of the first substring contactor in the open state in response to identifying the overtemperature condition in a predetermined subset plurality of the plurality of battery cells.

In any of the aspects or embodiments described above and herein, each of the substring assemblies may further include a second substring contactor and a second substring controller, the second substring contactor may be electrically connected in series with the battery substring, the second substring contactor may be positionable in the closed state or the open state, the second substring controller may be connected in communication with the second substring contactor and configured to control the position of the second substring contactor in the closed state or the open state, and the cell temperature sensor for each of the plurality of battery cells may be connected in signal communication with the first substring controller.

In any of the aspects or embodiments described above and herein, the propulsion system may further include an electrical distribution system, the electrical distribution system may include at least a first string contactor for each of the plurality of battery strings, and the first substring contactor may be electrically connected with and between the battery substring and the first string contactor of the first battery string.

In any of the aspects or embodiments described above and herein, the propulsion system may further include a controller connected in signal communication with the first substring controller, and the controller may include a processor connected in signal communication with a non-transitory memory storing instructions which, when executed by the processor, may cause the processor to determine a quantity of the plurality of substring assemblies having the first substring contactor in the open state.

In any of the aspects or embodiments described above and herein, the instructions, when executed by the processor, may further cause the processor to determine a remaining battery energy of the battery based on the determined quantity of the plurality of substring assemblies having the first substring contactor in the open state.

In any of the aspects or embodiments described above and herein, the propulsion system may further include a propulsor, an electric motor, and an electrical distribution system, the electric motor may be coupled with the propulsor, and the electrical distribution system may be configured to electrically interconnect the electric motor with the battery.

According to another aspect of the present disclosure, a propulsion system for an aircraft includes a battery. The battery includes a plurality of battery strings configured to be electrically connected together in parallel. A first battery string of the plurality of battery strings includes a plurality of substring assemblies. Each of the substring assemblies includes a battery substring, a first substring contactor, a first substring simple electronic hardware (SEH) controller, a second substring contactor, and a second substring SEH controller. The battery substring includes a plurality of battery cells electrically connected together. The first substring contactor is electrically connected in series with the battery substring. The second substring contactor is electrically connected in series with the battery substring and opposite the battery substring from the first substring contactor. The first substring contactor and the second substring contactor are each positionable in a closed state or an open state. The first substring SEH controller is connected in communication with the first substring contactor and configured to control a position of the first substring contactor in the closed state or the open state. The second substring SEH controller is connected in communication with the second substring contactor and configured to control the position of the second substring contactor in the closed state or the open state.

In any of the aspects or embodiments described above and herein, the propulsion system may further include a battery sensor assembly including a cell temperature sensor for each of the plurality of battery cells, the cell temperature sensor for each of the plurality of battery cells may be connected in signal communication with the first substring SEH controller and the second substring SEH controller.

In any of the aspects or embodiments described above and herein, the first substring SEH controller may be configured to identify a presence or an absence of an overtemperature condition in each of the plurality of battery cells using the cell temperature sensor for each of the plurality of battery cells, the presence of the overtemperature condition may be identified by the first substring SEH controller for each one of the plurality of battery cells where a measured cell temperature of each respective one of the plurality of battery cells is greater than a cell temperature threshold.

In any of the aspects or embodiments described above and herein, the second substring SEH controller may be configured to identify a presence or an absence of the overtemperature condition in each of the plurality of battery cells using the cell temperature sensor for each of the plurality of battery cells, the presence of the overtemperature condition may be identified by the second substring SEH controller for each one of the plurality of battery cells where the measured cell temperature of each respective one of the plurality of battery cells is greater than the cell temperature threshold.

In any of the aspects or embodiments described above and herein, the propulsion system may further include an electrical distribution system, the electrical distribution system may include at least a first string contactor for each of the plurality of battery strings, and the first substring contactor may be electrically connected with and between the battery substring and the first string contactor of the first battery string.

According to another aspect of the present disclosure, a propulsion system for an aircraft includes a battery and a battery sensor assembly. The battery includes a plurality of battery strings. A first battery string of the plurality of battery strings includes a plurality of substring assemblies configured to be electrically connected together in parallel. Each of the substring assemblies includes a battery substring, a first substring contactor, and a first substring controller. The battery substring includes a plurality of battery cells electrically connected together. The first substring contactor is electrically connected in series with the battery substring. The first substring contactor is positionable in a closed state or an open state. The first substring controller is connected in communication with the first substring contactor and configured to control a position of the first substring contactor in the closed state or the open state. The battery sensor assembly includes a cell temperature sensor for each of the plurality of battery cells. The cell temperature sensor for each of the plurality of battery cells is connected in signal communication with the first substring controller. The first substring controller is configured to identify a presence or an absence of an overtemperature condition in each of the plurality of battery cells using the cell temperature sensor and, in response to identifying the presence of the overtemperature condition in one or more of the plurality of battery cells, control the first substring contactor to the open state.

In any of the aspects or embodiments described above and herein, the first substring controller may be a simple electronic hardware (SEH) controller.

In any of the aspects or embodiments described above and herein, each of the substring assemblies may further include a second substring contactor and a second substring controller, the second substring contactor may be electrically connected in series with the battery substring, the second substring contactor may be positionable in the closed state or the open state, the second substring controller may be connected in communication with the second substring contactor and configured to control the position of the second substring contactor in the closed state or the open state, and the cell temperature sensor for each of the plurality of battery cells may be connected in signal communication with the first substring controller.

In any of the aspects or embodiments described above and herein, the propulsion system may further include an electrical distribution system, the electrical distribution system may include at least a first string contactor for each of the plurality of battery strings, and the first substring contactor may be electrically connected with and between the battery substring and the first string contactor of the first battery string.

In any of the aspects or embodiments described above and herein, the presence of the overtemperature condition may be identified by the first substring controller where a measured cell temperature of each respective one of the plurality of battery cells is greater than a cell temperature threshold and the absence of the overtemperature condition may be identified by the first substring controller where the measured cell temperature of each respective one of the plurality of battery cells is less than the cell temperature threshold.

The foregoing features and elements may be combined in various combinations without exclusivity, unless expressly indicated otherwise. For example, aspects and/or embodiments of the present disclosure may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### DESCRIPTION OF THE DRAWINGS

FIG. 1 illustrates an aircraft including a propulsion system, in accordance with one or more embodiments of the present disclosure.
FIG. 2 schematically illustrates a cutaway, side view of an aircraft propulsion system, in accordance with one or more embodiments of the present disclosure.
FIG. 3 schematically illustrates an electrical assembly for the aircraft propulsion system, said electrical assembly including a battery, in accordance with one or more embodiments of the present disclosure.
FIG. 4 schematically illustrates a battery string of the battery, in accordance with one or more embodiments of the present disclosure.
FIG. 5 schematically illustrates a battery substring assembly of the battery string, in accordance with one or more embodiments of the present disclosure.
FIG. 6 schematically illustrates a controller processing system, in accordance with one or more embodiments of the present disclosure.

### DETAILED DESCRIPTION

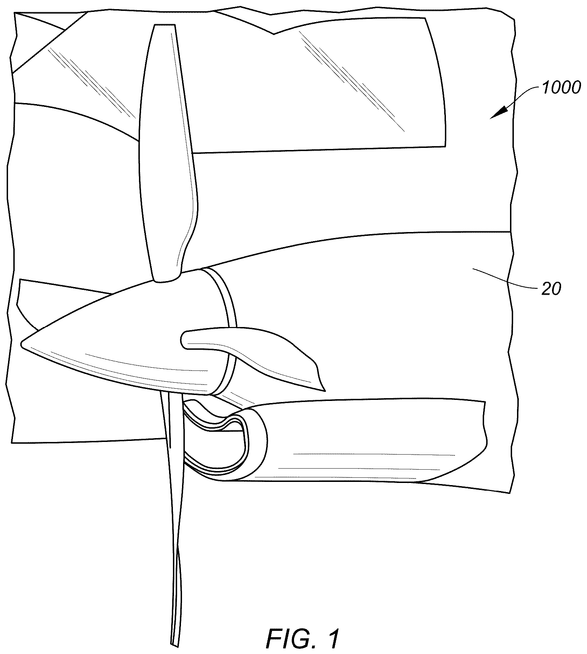

FIG. 1 illustrates an aircraft 1000 including at least one propulsion system 20. Briefly, the aircraft may be a fixed-wing aircraft (e.g., an airplane), a rotary-wing aircraft (e.g., a helicopter), a tilt-rotor aircraft, a tilt-wing aircraft, or another aerial vehicle. Moreover, the aircraft may be a manned aerial vehicle or an unmanned aerial vehicle (UAV, e.g., a drone).

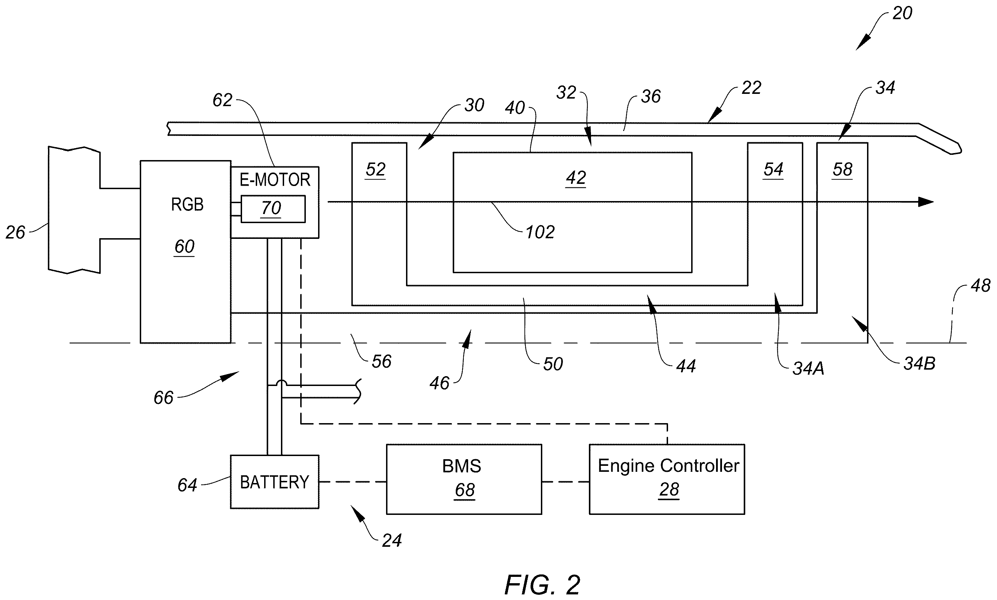

FIG. 2 schematically illustrates a cutaway, side view of the propulsion system 20. The propulsion system 20 of FIG. 2 includes an engine 22, an electrical assembly 24, a propulsor 26, and an engine controller 28. The engine 22 of FIG. 2 is configured as a turboprop gas turbine engine. However, the present disclosure is not limited to any particular configuration of gas turbine engine for the propulsion system 20, and examples of gas turbine engine configurations for the propulsion system 20 may include, but are not limited to, a turbofan engine, a turbojet engine, a propfan engine, or the like. Aspects of the present disclosure may be equally applicable to aircraft propulsion systems including other engine configurations such as, but not limited to, rotary engines, piston engines, and the like, or to electric aircraft propulsion systems (e.g., battery-electric propulsion systems, fuel-cell-electric propulsion systems, etc.). Aspects of the present disclosure may also be equally applicable to aircraft engines which are not part of a propulsion system, for example, an engine for an auxiliary power unit (APU).

The engine 22 of FIG. 2 includes a compressor section 30, a combustor section 32, a turbine section 34, and an engine static structure 36. The combustor section 32 includes a combustor 40 (e.g., an annular combustor). The combustor 40 forms a combustion chamber 42. The turbine section 34 includes a high-pressure turbine section 34A and a power turbine section 34B.

Components of the compressor section 30 and the turbine section 34 of FIG. 2 form a first rotational assembly 44 (e.g., a high-pressure spool) and a second rotational assembly 46 of the engine 22. The first rotational assembly 44 and the second rotational assembly 46 are mounted for rotation about a rotational axis 48 (e.g., an axial centerline) of the engine 22 relative to the engine static structure 36.

The first rotational assembly 44 includes a first shaft 50, a bladed compressor rotor 52 for the compressor section 30, and a bladed first turbine rotor 54 for the high-pressure turbine section 34A. The first shaft 50 interconnects the bladed compressor rotor 52 and the bladed first turbine rotor 54.

The second rotational assembly 46 of FIG. 2 includes a second shaft 56 and a bladed second turbine rotor 58 for the power turbine section 34B. The second shaft 56 is connected to the bladed second turbine rotor 58. The second shaft 56 operably connects (e.g., directly or indirectly connects) the bladed second turbine rotor 58 with the propulsor 26. For example, the second shaft 56 of FIG. 2 is coupled with the propulsor 26 by a gear box 60 (e.g., a reduction gear box (RGB)). The gear box 60 includes a gear assembly (e.g., an epicyclic gear assembly) coupling the second shaft 56 and the propulsor 26. The gear assembly may be a reduction gear assembly configured to drive rotation of the propulsor 26 at a reduced rotational speed relative to the second shaft 56. Of course, the second shaft 56 may alternatively be directly connected to the propulsor 26 to drive the propulsor 26 at the same rotational speed as the second shaft 56.

The engine static structure 36 includes engine casings, cowlings, and other fixed (e.g., non-rotating) structures of the engine 22 which house and/or support components of the engine 22 such as, but not limited to, those of the compressor section 30, the combustor section 32, and the turbine section 34. The engine static structure 36 includes one or more bearing assemblies and/or gear trains configured to rotationally support and/or interconnect components of the first rotational assembly 44 and the second rotational assembly 46.

The electrical assembly 24 of FIG. 2 includes an electric motor 62, a battery 64, an electrical distribution system 66, and a battery management system (BMS) 68.

The electric motor 62 is electrically connected to the electrical distribution system 66. The electric motor 62 includes a rotor 70. The rotor 70 is coupled to the propulsor 26 by the gear box 60. For example, the gear box 60 may couple both of the second shaft 56 and the rotor 70 to the propulsor 26 to facilitate driving rotation of the propulsor 26 with the bladed second turbine rotor 58 (e.g., via the second shaft 56), the electric motor 62 (e.g., the rotor 70), or a combination of the bladed second turbine rotor 58 and the electric motor 62. The electric motor 62 may additionally include or be electrically connected with to receive power from a motor control unit (e.g., an inverter) configured to control electric power characteristics (e.g., frequency, voltage, current) supplied to the electric motor 62 (e.g., windings of the electric motor 62), for example, to control a rotation speed and/or torque of the rotor 70.

The battery 64 is electrically connected to the electrical distribution system 66. The battery 64 is configured to selectively supply electrical power to the electrical distribution system 66 independently (e.g., as a single power source for the electrical assembly 24) or in combination with one or more other electrical power sources (e.g., an electrical generator). As will be discussed in further detail, the battery 64 may include a plurality of battery strings, battery sub-strings, battery modules, battery cells, and/or the like electrically connected together in series and/or parallel as necessary to configure the battery 64 with the desired electrical characteristics (e.g., voltage output, current output, storage capacity, etc.). The present disclosure is not limited to any particular configuration of the battery 64.

During operation of the propulsion system 20 of FIG. 2, ambient air enters the propulsion system 20 through an air intake into and through a core flow path of the engine 22. The ambient air flow along the core flow path is compressed in the compressor section 30 and directed into the combustor 40. Fuel is injected into the combustor 40 (e.g., the combustion chamber 42) and mixed with the compressed air to provide a fuel-air mixture. This fuel-air mixture is ignited, and combustion products thereof flow through the high-pressure turbine section 34A and the power turbine section 34B and are exhausted from the propulsion system 20. The bladed first turbine rotor 54 and the bladed second turbine rotor 58 rotationally drive the first rotational assembly 44 and the second rotational assembly 46, respectively, in response to the combustion gas flow through the high-pressure turbine section 34A and the power turbine section 34B. The second rotational assembly 46 (e.g., the second shaft 56) may drive rotation of the propulsor 26, for example, through the gear box 60. The electric motor 62 may be selectively operated (e.g., by the engine controller 28) to drive rotation of the propulsor 26 independently or in combination with the engine 22 through the gear box 60.

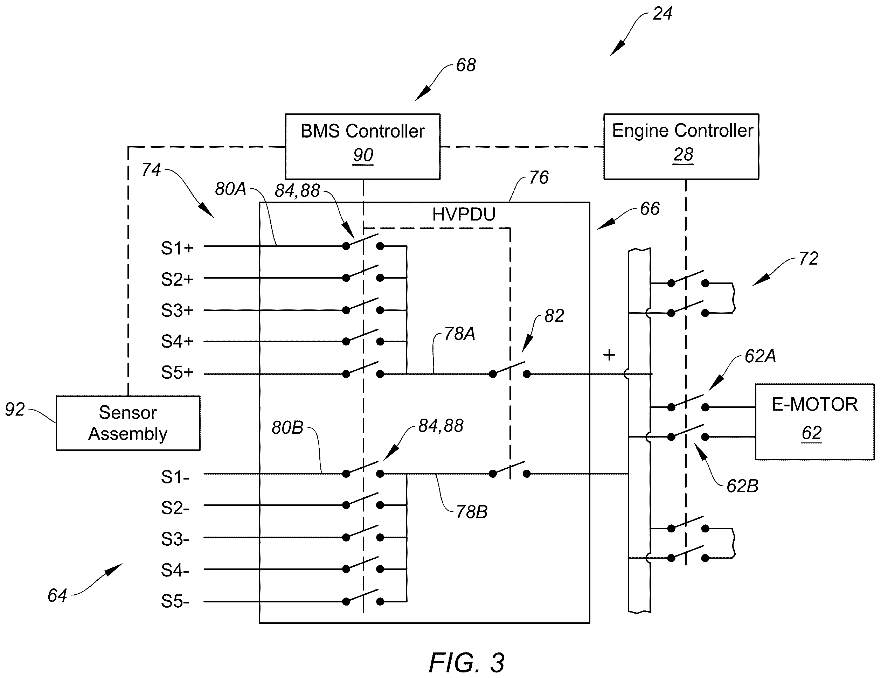

FIG. 3 schematically illustrates a portion of the electrical assembly 24 including the battery 64, the electrical distribution system 66, and the battery management system 68. The electrical assembly 24 is configured to supply electrical power to one or more electrical loads 72 of the propulsion system 20 (see FIG. 2) and/or the aircraft 1000 (see FIG. 1) such as, but not limited to, the electric motor 62. The battery 64 of FIG. 3 includes a plurality of battery strings 74 configured to be electrically connected together in parallel, for example, by the electrical distribution system 66. The battery strings 74 of FIG. 3 include five (5) battery strings 74, S1-5; however, the present disclosure is not limited to any particular quantity of the battery strings 74 of the battery 64.

The electrical distribution system 66 electrically interconnects components of the electrical assembly 24. The electrical distribution system 66 includes switchgear, cables, wires, breakers, switches, contactors, electrical power conditional and/or conversion (e.g., AC to DC or DC to AC conversion) components, and/or other electrical components to effect the transfer of electrical power between components of the electrical assembly 24. For example, the electrical distribution system 66 of FIG. 3 electrically connects the electric motor 62 (and other electrical loads 72) with the battery 64. The electrical distribution system 66 may additionally be electrically connected with other electric power sources (e.g., an electrical generator) of the electrical assembly 24. The electrical distribution system 66 may additionally include one or more electrical power controllers, for example, to control a magnitude and/or direction of electrical current flow to components of the electrical assembly 24. The electrical distribution system 66 is configured to supply electrical power to the electrical loads 72 of the aircraft 1000, the propulsion system 20, and/or the engine 22.

The electrical distribution system 66 of FIG. 3 includes a high-voltage power distribution unit (HVPDU) 76. The HVPDU 76 includes a positive main battery line 78A and a negative main battery line 78B. The HVPDU 76 additionally includes, for each of the battery strings 74, a positive string line 80A and a negative string line 80B. The main battery lines 78A, 78B electrically interconnect the battery strings 74 with the electrical loads 72. The string battery lines 80A, 80B electrically connect each of the battery strings 74 with the main battery lines 78A, 78B. For example, the positive string lines 80A (e.g., S1+, S2+, S3+, S4+, S5+) are electrically connected together at a positive battery line 78A and the negative string lines 80B (e.g., S1-, S2, S3-, S4-, S5-) are electrically connected together at the negative battery line 78B to electrically connect the battery strings 74 in parallel.

The HVPDU 76 further includes a main battery switch assembly 82 for the main battery lines 78A, 78B and a battery string switch assembly 84 for the string lines 80A, 80B of each of the battery strings 74. The main battery switch assembly 82 and the battery string switch assembly 84 of FIG. 3 each include electrical contactors configured to facilitate selective control of electrical current flow through the HVPDU 76, for example, along the main battery lines 78A, 78B and the string lines 80A, 80B. The contactors are selectively configurable (e.g., switchable) in and between a closed state or an open state to conduct or interrupt an electrical current flow, respectively. The contactors may include electrically-controlled relays or switches which may be controlled by an electrical control signal to position the respective contactors in the open state or the closed state. The present disclosure, switch assemblies 82, 84, however, are not limited to electrical contactors and other electrical power interruption devices, breakers, and switches may alternatively be used. The main battery switch assembly 82 and the battery string switch assembly 83 of FIG. 3 include main battery contactors 86 and string contactors 88 on each of the main battery lines 78A, 78B and the string lines 80A, 80B, respectively.

The battery management system 68 is configured to monitor, control, and facilitate protective functions for the battery 64. The battery management system 68 includes a BMS controller 90. The BMS controller 90 may be connected in electrical (e.g., signal) communication with each of the main battery contactors 86 and/or each of the string contactors 88 to control positions of the contactors 86, 88 in their closed and open positions. The battery management system 68 and its BMS controller 90 is configured to monitor conditions of the battery 64 such as, but not limited to, charging parameters, discharge parameters, state of charge, state of health, temperature, voltage, current, battery faults, arc discharges, and the like, to facilitate operation and control of the electrical assembly 24 and the battery 64. The battery management system 68 includes a battery sensor assembly 92 connected in signal communication with the BMS controller 90. The battery sensor assembly 92 may include temperature sensors, voltage sensors, current sensors, and the like at various locations of the battery 64 to facilitate battery monitoring and protection functions of the BMS controller 90.

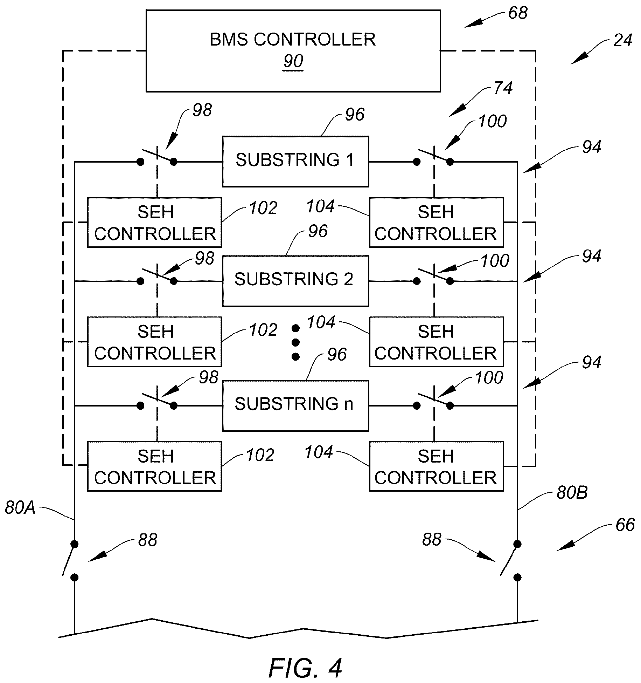

FIG. 4 schematically illustrates one of the battery strings 74. As shown in FIG. 4, one, more than one, or each of the battery strings 74 may include a plurality of substring assemblies 94. Each of the substring assemblies 94 of FIG. 4 includes a battery substring 96, a first substring contactor 98, a second substring contactor 100, a first substring controller 102 of the battery management system 68, and a second substring controller 104 of the battery management system 68. However, in some embodiments, the substring assemblies 94 may include only the first substring contactor 98 (e.g., a single substring contactor) and the first substring controller 102 (e.g., a single substring controller). The battery substrings 96 of each of the substring assemblies 94 are electrically connectable together in parallel to form the respective one of the battery strings 74.

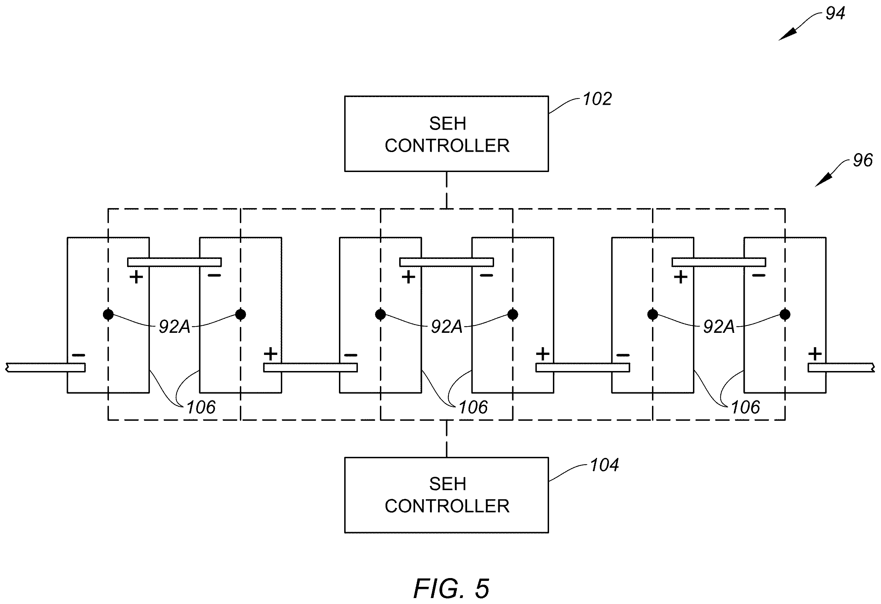

FIG. 5 schematically illustrates the battery substring 96. The battery substring 96 of FIG. 5 includes a plurality of battery cells 106 electrically connected together to form the battery substring 96. For example, each of the battery cells 106 of the battery substring 96 may be electrically connected in series and/or parallel to one or more other battery cells 106 of the battery substring 96. The battery cells 106 may be arranged as a plurality of interconnected battery modules with each battery module including a plurality of battery cells 106 electrically connected together as a discrete battery unit. The battery cells 106 may be understood to as a smallest discrete unit of the battery 64 configured to convert chemical energy to electrical energy and vice versa (e.g., each of the battery cells 106 may include a cathode, an anode, and an electrolyte). The battery cells 106 may be configured as cylindrical cells, pouch cells, prismatic cells, and the like, and the present disclosure is not limited to any particular configuration of the battery cells 106. The battery 64 (e.g., and its battery cells 106) is configured as a rechargeable battery having a battery chemistry such as, but not limited to, lead acid, nickel cadmium (NiCd), nickel-metal hydride (Ni-MH), lithium-ion (Li-ion), lithium-polymer (Li-poly), lithium metal, and the like.

The first substring contactor 98 and the second substring contactor 100 are configured to facilitate selective control of electrical current flow for the battery substring 96. Similar to the contactors 86, 88, the substring contactors 98, 100 are selectively configurable (e.g., switchable) in and between a closed state or an open state to conduct or interrupt an electrical current flow, respectively. The first substring contactor 98 is electrically connected between the battery substring 96 and the string contactor 88 on the positive string line 80A. The second substring contactor 100 is electrically connected between the battery substring 96 and the string contactor 88 on the negative string line 80B.

The first substring controller 102 and the second substring controller 104 are configured to control positions of the first substring contactor 98 and the second substring contactor 100, respectively, in the closed state or the open state. The first substring controller 102 is connected in communication (e.g., signal communication, electrical communication, etc.) with the first substring contactor 98. The first substring controller 102 is further connected in signal communication with the BMS controller 90. The second substring controller 104 is connected in communication (e.g., signal communication, electrical communication, etc.) with the second substring contactor 100. The second substring controller 104 is further connected in signal communication with the BMS controller 90.

As shown in FIG. 5, for example, the battery sensor assembly 92 includes a cell temperature sensor 92A for each of the battery cells 106. The cell temperature sensor 92A may be configured as a resistance temperature detector (RTD), a thermocouple, or another suitable temperature sensor. The first substring controller 102 and the second substring controller 104 are connected in signal communication with the cell temperature sensor 92A of each of the battery cells 106 of the battery substring 96. The first substring controller 102 and the second substring controller 104 of FIG. 5 are connected in signal communication with a same cell temperature sensor 92A of each of the battery cells 106; however, the first substring controller 102 and the second substring controller 104 may alternatively be connected in signal communication with discrete cell temperature sensors of each of the battery cells 106.

The first substring controller 102 and the second substring controller 104 are each configured as simple electronic hardware (SEH) controllers. As used herein, the term "simple electronic hardware (SEH)" refers to electronic hardware that is fully analyzable and testable. Electronic hardware may be classified as simple electronic hardware (SEH), for example, under Radio Technical Commission for Aeronautics Design Assurance Guidance for Airborne Electronic Hardware (DO-254) and/or European Organisation for Civil Aviation Equipment (EUROCAE) Design Assurance Guidance for Airborne Electronic Hardware ED-80 standards, if a comprehensive combination of deterministic tests and analyses appropriate to the design assurance level (DAL) of the electronic hardware can ensure correct functional performance under all foreseeable operating conditions with no anomalous behavior. Performance testing of simple electronic hardware (SEH) may include methods such as visual inspection, basic input-output testing, or straightforward analysis to conclusively establish that the electronic hardware performs as expected without the need for advanced analytical verification methods such as simulation or other complex analytical processes which may be necessary for complex electronic hardware (CEH). Simple electronic hardware (SEH) may typically lack complex state behavior, such as embedded processors or field-programmable gate arrays (FPGAs) with intricate logic. Simple electronic hardware (SEH) may include electronic hardware such as, but not limited to, discrete logic circuits (e.g., simple logic gates which perform only straightforward, predictable functions which can be easily analyzed and tested), signal conditioners (e.g., electronic hardware which prepares or conditions signals without modifying their fundamental characteristics), power regulators or simple power distribution circuits, basic analog circuits (e.g., operational amplifiers with a clear input-output relationship), relays and switches (e.g., mechanical or solid-state relays that control the on/off state of electrical circuits), basic communication interfaces facilitating limited data transmission (e.g., universal asynchronous receiver-transmitters (UARTs) with no advanced protocol handling), and the like.

The engine controller 28 may control operating parameters of the engine 22 including, but not limited to, fuel flow, stator vane position (e.g., variable compressor inlet guide vane (IGV) position), compressor air bleed valve position, shaft (e.g., first shaft 50 and/or second shaft 56) torque and/or rotation speed, etc. so as to control an engine power or performance of the propulsion system 20. The engine controller 28 is connected in signal communication with electric motor contactors 62A, 62B for the electric motor 62. The engine controller 28 is configured to control positions of the electric motor contactors 62A, 62B in their respective closed or open states to energize or deenergize the electric motor 62 to facilitate propulsion using the propulsor 26 (see FIG. 2). In some embodiments, the engine controller 28 may be part of a full authority digital engine control (FADEC) system for the propulsion system 20 and its engine 22. The engine controller 28 is connected in signal communication with the BMS controller 90. The engine controller 28 receives signals from the BMS controller 90 to facilitate operation and control of the engine 22 and the electrical assembly 24 by the engine controller 28 or by the engine controller 28 and the BMS controller 90 in combination.

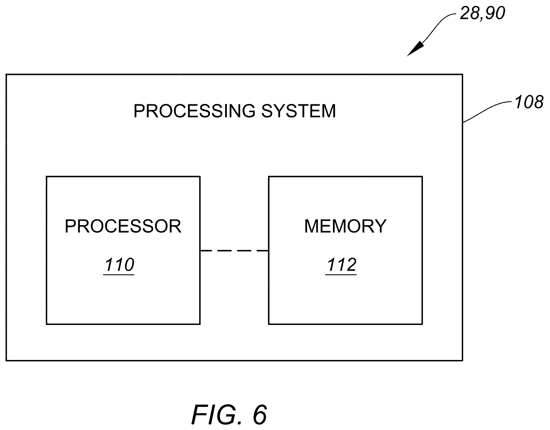

Referring briefly to FIG. 6, the engine controller 28 and the BMS controller 90 each include at least one discrete processing system 108. The processing system 108 includes a processor 110 connected in signal communication with memory 112. The processor 110 may include any type of computing device, computational circuit, processor(s), central processing unit (CPU), graphics processing unit (GPU), computer, or the like capable of executing a series of instructions that are stored in memory 112. Instructions can be directly executable or can be used to develop executable instructions. For example, instructions can be realized as executable or non-executable machine code or as instructions in a high-level language that can be compiled to produce executable or non-executable machine code. Further, instructions also can be realized as or can include data. Computer-executable instructions also can be organized in any format, including routines, subroutines, programs, data structures, objects, modules, applications, applets, functions, etc. The instructions may include an operating system, and/or executable software modules such as program files, system data, buffers, drivers, utilities, and the like. The executable instructions may apply to any functionality described herein to enable the processing system 108 and its processor 110 to accomplish the same algorithmically and/or coordination of electrical assembly 24 components including, but not limited to, the electric motor 62, the battery 64, the electric distribution system 66, and the battery management system 68. The memory 112 may include a single memory device or a plurality of memory devices (e.g., a computer-readable storage device that can be read, written, or otherwise accessed by a general purpose or special purpose computing device, including any processing electronics and/or processing circuitry capable of executing instructions). The present disclosure is not limited to any particular type of memory device, which may be non-transitory, and may include read-only memory, random access memory, volatile memory, non-volatile memory, static memory, dynamic memory, flash memory, cache memory, volatile or non-volatile semiconductor memory, optical disk storage, magnetic disk storage, magnetic tape, other magnetic storage devices, or any other medium capable of storing one or more instructions, and/or any device that stores digital information. The memory device(s) may be directly and/or indirectly coupled to the respective one of the engine controller 28 or the BMS controller 90. The processing system 108 may include, or may be in communication with, a user interface including one or more inputs devices and/or one or more output devices, for example, an input device that enables a user to enter data and/or instructions and an output device configured to display information (e.g., a visual display or a printer), or to transfer data, etc. Communications between the processing system 108 and external electrical or electronic devices may be via a hardwire connection or via a wireless connection. A person of skill in the art will recognize that portions of the processing system 108 may assume various forms (e.g., digital signal processor, analog device, etc.).

During operation of the electrical assembly 24, the cell temperatures of the battery cells 106 may be monitored using the cell temperature sensor 92A for each of the battery cells 106 to facilitate continued safe operation of the battery 64. Battery cells, and particularly those having a lithium-ion chemistry, may be susceptible in some rare cases to thermal runaway, wherein the battery cell enters an uncontrollable self-heating state. Accordingly, monitoring the cell temperatures of the battery cells 106 may be useful for identifying and preventing or reducing the severity of thermal runaway events. Of course, temperature monitoring and control of battery cells may also be important for cell configurations and chemistries other than lithium-ion cells.

The first substring controller 102 and the second substring controller 104 are configured to control the first substring contactor 98 and the second substring contactor 100, respectively, into the open state in response to identification of overtemperature conditions of one or more of the battery cells 106 of the battery substring 96. Each of the first substring controller 102 and the second substring controller 104 is configured to identify a presence or an absence of an overtemperature condition in each of the battery cells 106 using the cell temperature sensors 92A. The first substring controller 102 and the second substring controller 104 may identify the presence of the overtemperature condition in a given one of the battery cells 106 where a cell temperature of the given battery cell 106 is greater than a cell temperature threshold. The first substring controller 102 and the second substring controller 104 may identify the absence of the overtemperature condition in a given one of the battery cells 106 where a cell temperature of the given battery cell 106 is less than the cell temperature threshold. The first substring controller 102 and the second substring controller 104 may control the first substring contactor 98 and the second substring contactor 100, respectively, into the open state in response to identifying the overtemperature condition in one of the battery cells 106. Alternatively, the first substring controller 102 and the second substring controller 104 may control the first substring contactor 98 and the second substring contactor 100, respectively, into the open state in response to identifying the overtemperature condition in a predetermined quantity (e.g., a subset plurality) of the battery cells 106. By independently isolating the battery substring 96 (and its battery cells 106) in response to an identified overtemperature condition, the substring assemblies 94 facilitate continued operation of the remainder of the battery substrings 96 of the battery string 74, thereby facilitating improved availability of stored energy in the battery 64 for propulsion or other electrical loads of the propulsion system 20 or the aircraft 1000 (see FIG. 1). The first substring controller 102 and the second substring controller 104 may send a signal to the BMS controller 90 and/or the engine controller 28 identifying particular substring assembly 94 (e.g., the battery substring 96) which was electrically isolated in response to the identified cell overtemperature condition(s). The BMS controller 90 and/or the engine controller 28 may determine a quantity of the substring assemblies 94 which have been lost (e.g., electrically isolated in response to overtemperature conditions). The BMS controller 90 and/or the engine controller 28 may determine a remaining stored energy (e.g., charge) of the battery 64 and generate a message or other notification for a pilot or other operator at the aircraft 1000 cockpit.

While the principles of the disclosure have been described above in connection with specific apparatuses and methods, it is to be clearly understood that this description is made only by way of example and not as limitation on the scope of the disclosure. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected, or the like may include permanent, removable, temporary, partial, full and/or any other possible attachment option.

The terms "substantially," "about," "approximately," and other similar terms of approximation used throughout this patent application are intended to encompass variations or ranges that are reasonable and customary in the relevant field. These terms should be construed as allowing for variations that do not alter the basic essence or functionality of the invention. Such variations may include, but are not limited to, variations due to manufacturing tolerances, materials used, or inherent characteristics of the elements described in the claims, and should be understood as falling within the scope of the claims unless explicitly stated otherwise.

No element, component, or method step in the present disclosure is intended to be dedicated to the public regardless of whether the element, component, or method step is explicitly recited in the claims. No claim element herein is to be construed under the provisions of 35 U.S.C. 112(f) unless the element is expressly recited using the phrase "means for." As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the disclosures may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the disclosures--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements.

## Claims

1. A propulsion system for an aircraft, the propulsion system comprising:
a battery including a plurality of battery strings configured to be electrically connected together in parallel, a first battery string of the plurality of battery strings including a plurality of substring assemblies, each of the substring assemblies including a battery substring, a first substring contactor, and a first substring controller,
the battery substring includes a plurality of battery cells electrically connected together,
the first substring contactor is electrically connected in series with the battery substring, the first substring contactor is positionable in a closed state or an open state,
the first substring controller is connected in communication with the first substring contactor and configured to control a position of the first substring contactor in the closed state or the open state; and
a battery sensor assembly including a cell temperature sensor for each of the plurality of battery cells, the cell temperature sensor for each of the plurality of battery cells connected in signal communication with the first substring controller.

2. The propulsion system of claim 1, wherein the first substring controller is a simple electronic hardware (SEH) controller.

3. The propulsion system of claim 1 or 2, wherein the first substring controller is configured to identify a presence or an absence of an overtemperature condition in each of the plurality of battery cells using the cell temperature sensor for each of the plurality of battery cells, the presence of the overtemperature condition identified for each one of the plurality of battery cells where a measured cell temperature of each respective one of the plurality of battery cells is greater than a cell temperature threshold.

4. The propulsion system of claim 3, wherein the first substring controller is configured to control the position of the first substring contactor in the open state in response to identifying the overtemperature condition in one of the plurality of battery cells, or,
wherein the first substring controller is configured to control the position of the first substring contactor in the open state in response to identifying the overtemperature condition in a predetermined subset plurality of the plurality of battery cells.

5. The propulsion system of any preceding claim, wherein each of the substring assemblies further includes a second substring contactor and a second substring controller, the second substring contactor is electrically connected in series with the battery substring, the second substring contactor is positionable in the closed state or the open state, the second substring controller is connected in communication with the second substring contactor and configured to control the position of the second substring contactor in the closed state or the open state, and the cell temperature sensor for each of the plurality of battery cells is connected in signal communication with the first substring controller; and/or
further comprising an electrical distribution system, the electrical distribution system including at least a first string contactor for each of the plurality of battery strings, and the first substring contactor is electrically connected with and between the battery substring and the first string contactor of the first battery string.

6. The propulsion system of any preceding claim, further comprising a controller connected in signal communication with the first substring controller, the controller including a processor connected in signal communication with a non-transitory memory storing instructions which, when executed by the processor, cause the processor to:
determine a quantity of the plurality of substring assemblies having the first substring contactor in the open state.

7. The propulsion system of claim 6, wherein the instructions, when executed by the processor, further cause the processor to determine a remaining battery energy of the battery based on the determined quantity of the plurality of substring assemblies having the first substring contactor in the open state.

8. The propulsion system of any preceding claim, further comprising a propulsor, an electric motor, and an electrical distribution system, the electric motor is coupled with the propulsor, and the electrical distribution system is configured to electrically interconnect the electric motor with the battery.

9. A propulsion system for an aircraft, the propulsion system comprising:
a battery including a plurality of battery strings configured to be electrically connected together in parallel, a first battery string of the plurality of battery strings including a plurality of substring assemblies, each of the substring assemblies including a battery substring, a first substring contactor, a first substring simple electronic hardware (SEH) controller, a second substring contactor, and a second substring SEH controller;
the battery substring includes a plurality of battery cells electrically connected together,
the first substring contactor is electrically connected in series with the battery substring, the second substring contactor is electrically connected in series with the battery substring and opposite the battery substring from the first substring contactor, and the first substring contactor and the second substring contactor are each positionable in a closed state or an open state,
the first substring SEH controller is connected in communication with the first substring contactor and configured to control a position of the first substring contactor in the closed state or the open state; and
the second substring SEH controller is connected in communication with the second substring contactor and configured to control the position of the second substring contactor in the closed state or the open state.

10. The propulsion system of claim 9, further comprising a battery sensor assembly including a cell temperature sensor for each of the plurality of battery cells, the cell temperature sensor for each of the plurality of battery cells connected in signal communication with the first substring SEH controller and the second substring SEH controller.

11. The propulsion system of claim 10, wherein the first substring SEH controller is configured to identify a presence or an absence of an overtemperature condition in each of the plurality of battery cells using the cell temperature sensor for each of the plurality of battery cells, the presence of the overtemperature condition identified by the first substring SEH controller for each one of the plurality of battery cells where a measured cell temperature of each respective one of the plurality of battery cells is greater than a cell temperature threshold.

12. The propulsion system of claim 11, wherein the second substring SEH controller is configured to identify a presence or an absence of the overtemperature condition in each of the plurality of battery cells using the cell temperature sensor for each of the plurality of battery cells, the presence of the overtemperature condition identified by the second substring SEH controller for each one of the plurality of battery cells where the measured cell temperature of each respective one of the plurality of battery cells is greater than the cell temperature threshold.

13. The propulsion system of any of claims 9 to 12, further comprising an electrical distribution system, the electrical distribution system including at least a first string contactor for each of the plurality of battery strings, and the first substring contactor is electrically connected with and between the battery substring and the first string contactor of the first battery string.

14. A propulsion system for an aircraft, the propulsion system comprising:
a battery including a plurality of battery strings, a first battery string of the plurality of battery strings including a plurality of substring assemblies configured to be electrically connected together in parallel, each of the substring assemblies including a battery substring, a first substring contactor, and a first substring controller,
the battery substring includes a plurality of battery cells electrically connected together,
the first substring contactor is electrically connected in series with the battery substring, the first substring contactor is positionable in a closed state or an open state,
the first substring controller is connected in communication with the first substring contactor and configured to control a position of the first substring contactor in the closed state or the open state; and
a battery sensor assembly including a cell temperature sensor for each of the plurality of battery cells, the cell temperature sensor for each of the plurality of battery cells connected in signal communication with the first substring controller;
the first substring controller configured to identify a presence or an absence of an overtemperature condition in each of the plurality of battery cells using the cell temperature sensor and, in response to identifying the presence of the overtemperature condition in one or more of the plurality of battery cells, control the first substring contactor to the open state.

15. The propulsion system of claim 14, wherein the first substring controller is a simple electronic hardware (SEH) controller; and/or
wherein each of the substring assemblies further includes a second substring contactor and a second substring controller, the second substring contactor is electrically connected in series with the battery substring, the second substring contactor is positionable in the closed state or the open state, the second substring controller is connected in communication with the second substring contactor and configured to control the position of the second substring contactor in the closed state or the open state, and the cell temperature sensor for each of the plurality of battery cells is connected in signal communication with the first substring controller; and/or
further comprising an electrical distribution system, the electrical distribution system including at least a first string contactor for each of the plurality of battery strings, and the first substring contactor is electrically connected with and between the battery substring and the first string contactor of the first battery string; and/or
wherein the presence of the overtemperature condition is identified by the first substring controller where a measured cell temperature of each respective one of the plurality of battery cells is greater than a cell temperature threshold and the absence of the overtemperature condition is identified by the first substring controller where the measured cell temperature of each respective one of the plurality of battery cells is less than the cell temperature threshold.
